Europäisches Patentamt

European Patent Office

Office européen des brevets

(19)

(11) **EP 1 078 371 B1**

(12) **EUROPÄISCHE PATENTSCHRIFT**

(45) Veröffentlichungstag und Bekanntmachung des Hinweises auf die Patenterteilung:
**14.11.2001 Patentblatt 2001/46**

(21) Anmeldenummer: **99924698.6**

(22) Anmeldetag: **26.03.1999**

(51) Int Cl.⁷: $G11C\ 7/00$, G11C 27/02

(86) Internationale Anmeldenummer:
**PCT/DE99/00924**

(87) Internationale Veröffentlichungsnummer:
**WO 99/57726 (11.11.1999 Gazette 1999/45)**

(54) **SCHALTUNGSANORDNUNG MIT EINEM SENSORELEMENT UND EINEM NICHTFLÜCHTIGEN SPEICHERMITTEL**

CIRCUIT WITH A SENSOR AND NON-VOLATILE MEMORY

CIRCUIT COMPRENANT UN DETECTEUR ET UNE MEMOIRE NON VOLATILE

(84) Benannte Vertragsstaaten:
**DE FR GB IT**

(30) Priorität: **30.04.1998 DE 19819542**

(43) Veröffentlichungstag der Anmeldung:
**28.02.2001 Patentblatt 2001/09**

(73) Patentinhaber: **Infineon Technologies AG
81669 München (DE)**

(72) Erfinder:
• **MAZURE-ESPEJO, Carlos
D-85604 Zorneding (DE)**

• **ZELLER, Christoph
D-85521 Ottobrunn (DE)**

(74) Vertreter: **Zedlitz, Peter, Dipl.-Inf.
Patentanwalt,
Postfach 22 13 17
80503 München (DE)**

(56) Entgegenhaltungen:
**EP-A- 0 403 248       EP-A- 0 486 901
US-A- 5 325 050       US-A- 5 332 962**

EP 1 078 371 B1

**Beschreibung**

Die vorliegende Erfindung betrifft eine Schaltungsanordnung mit einem Sensor und einem Speichermittel zur nichtflüchtigen Speicherung einer von dem Sensor gelieferten Ladung.

Sensoren dienen zur Erfassung nicht-elektrischer Größen und zur Umsetzung in elektrisch messbare Größen, wie Strom, Spannung oder elektrische Ladung. Eine nichtflüchtige Speicherung der von dem Sensor gelieferten Ladung ist bislang mit einem erheblichen Aufwand verbunden. Als Beispiel seien hierzu CCD-Kameras genannt, die eine Vielzahl matrixähnlich angeordneter, lichtempfindlicher Sensoren aufweisen, an denen bei Lichteinfall eine elektrische Ladung generiert wird. Die an den einzelnen Sensoren generierten Ladungen werden ausgelesen und in einer Verstärkereinheit in Spannungen umgesetzt, mit denen eine Programmierung nichtflüchtiger Speicherzellen, wie Flash-EEPROMs, möglich ist. Neben dem großen Schaltungsaufwand, dem Vorsehen einer großen, zur Programmierung der EEPROMs geeigneten Versorgungsspannung und dem relativ großen Platzaufwand, der sich aus dem Vorsehen einer Verstärkerschaltung und der räumlich getrennten Anordnung der Sensor-matrix und der Speichermittel ergibt, ist bei derartigen Vorrichtungen insbesondere nachteilig, dass die genannten nichtflüchtigen Speicher lediglich die Speicherung digitaler Werte erlauben.

Ist beispielsweise im Falle von Lichtsensoren die von den Sensoren generierte Ladungsmenge helligkeitsabhängig, so geht bei Speicherung dieser Ladung mittels der oben genannten Speichermittel unweigerlich ein Teil der Helligkeitsinformation verloren. Ist jedem Sensor nur eine Speicherzelle zugeordnet, kann anhand des gespeicherten Wertes lediglich unterschieden werden, ob sich die Helligkeit an dem Sensor oberhalb oder unterhalb eines vorgegebenen Schwellwertes befand. Eine exaktere Speicherung des von dem Sensor gelieferten analogen Wertes erfordert eine Analog-Digital-Wandlung dieses Analog-Wertes und eine Abspeicherung des hierbei erhaltenen Digital-Wertes, wobei die Anzahl der zur Speicherung des Digital-Wertes erforderlichen Speicherzellen der Anzahl der Stellen des Digital-Wertes abhängt.

In der US 5,325,050 sowie der US 5,332,962 sind Schaltungsanordnungen mit einem Sensor und einem Speichermittel zur nichtflüchtigen Speicherung einer von dem Sensor gelieferten Ladung beschrieben, wobei das Speichermittel ein Kondensator mit einem ferroelektrischen Speicherdielektrikum ist, der wenigstens zeitweise mit dem Sensorelement verbunden ist.

Die beschriebenen Schaltungsanordnungen weisen fernerhin eine zeitweise an den ferroelektrischen Kondensator angeschlossene DC-Spannungsquelle auf, um eine spontane Polarisation des Dielektrikums zu erzeugen und einen Polarisationsdetektor um festzustellen, ob sich die Polarisation des ferroelektrischen Kondensators aufgrund eines vom Sensor gelieferten Spannungssignals geändert hat.

Auf diese Weise kann wie bei den o. a. beschriebenen Schaltungsanordnungen lediglich festgestellt werden, ob ein vorgegebener Maximalwert des Sensorsignals überschritten wurde. Auch hier liegt folglich nur eine Analog-Digital-Wandlung eines analogen Sensorsignals vor.

Dokument EP O 403 248 A2 betrifft einen Photosensor mit angeschlossenem Analogspeicher. Wie sich auf einfache Weise und mit welchen Mitteln sich eine derartige Schaltungsanordnung realisieren lässt, ist nicht offenbart.

Der vorliegenden Erfindung lag daher die Aufgabe zugrunde, eine Schaltungsanordnung mit einem Sensor und einem Speichermittel zur Verfügung zu stellen, die auf einfache Weise die Speicherung und Auswertung analoger von dem Sensor gelieferter Werte erlaubt, die insbesondere als integrierte Schaltungsanordnung realisierbar ist und bei der sich die oben genannten Nachteile nicht ergeben.

Dieses Ziel wird durch die eingangs genannte Schaltungsanordnung erreicht, bei der das Speichermittel ein Kondensator mit einem ferroelektrischen Speicherdielektrikum ist, der wenigstens zeitweise parallel zu Anschlußklemmen des Sensors ange-schlossen ist.

Der Kondensator mit dem ferroelektrischen Speicherdielektrikum ermöglicht eine nichtflüchtige Speicherung der von dem Sensor gelieferten Ladung. Der Kondensator ist gegebenenfalls über einen Schalter, an den Sensor angeschlossen. Somit besteht die Möglichkeit, Sensor und Kondensator in demselben Halbleiterkörper zu integrieren, woraus ein sehr geringer Platzaufwand bei Realisierung der erfindungsgemäßen Schaltungsanordnung resultiert. Durch matrixartige Anordnung einer entsprechend großen Anzahl lichtempfindlicher Sensoren, wie Fotodioden, denen jeweils ein Kondensator mit ferroelektrischen Speicherdielektrikum zugeordnet ist, können damit auf einem Chip alle Bauelemente untergebracht werden, die erforderlich sind, Bilder zu erfassen und zu speichern.

Die vorliegende Erfindung ist jedoch nicht auf die Verwendung lichtempfindlicher Sensoren beschränkt. Vielmehr findet sie überall dort Verwendung, wo ein Einsatz von Sensoren und eine Speicherung der von den Sensoren gelieferten Werte erforderlich ist und wo eine möglichst kleine Bauform gewünscht ist, wie in der Mikromechanik.

Vorteilhafte Ausgestaltungen der Erfindung sind Gegenstand der Unteransprüche.

Zur Speicherung der von dem Sensor gelieferten Ladung besteht die Möglichkeit, den Sensor durch eine feste Leitungsverbindung dauerhaft parallel zu den Anschlußklemmen des Sensors zu schalten. Dies ist beispielsweise bei Verwendung der erfindungsgemäßen Schaltungsanordnung zur Bilderfassung eine bevorzugte Ausführungsform, wenn eine Blende vor den Lichtsensoren vorgesehen ist, die nur eine zeitweise Belichtung der Lichtsensoren erlaubt. Sind die Lichtsensoren als Fotodioden ausgebildet, fällt bei Belichtung zwischen deren Anschlußklemmen eine annäherungsweise konstante Spannung ab, wobei der von den Sensoren gelieferte Strom bzw. die pro Zeiteinheit an die Kondensatoren gelieferte Ladung von der Lichtstärke an dem jeweiligen Lichtsensor abhängt. Die von den einzelnen Sensoren gelieferten, und wenigstens teilweise in den Kondensatoren gespeicherten Ladungen stellen damit ein Maß für die mittlere Beleuchtungsstärke an dem Sensor während geöffneter Blende dar. In den Kondensatoren ist somit eine Bildinformation gespeichert, wobei sich die Auflösung des Bildes aus der Anzahl der matrixartig angeordneten Lichtsensoren ergibt

Nach einer Ausführungsform der Erfindung ist vorgesehen, einen Schalter, der insbesondere als Transistor ausgebildet ist, zwischen eine Klemme des Kondensators und eine Anschlußklemme des Sensorelements zu schalten. Der Schalter erfüllt hier die Funktion der oben erwähnten Blende. Durch Schließen des Schalters wird der Zeitpunkt bestimmt, zu dem die von dem oder von den Sensoren generierte Ladung in den oder die Kondensatoren eingespeichert werden soll.

Vorzugsweise ist zum Auslesen der in dem Kondensator gespeicherten Ladung eine an wenigstens eine Klemme des Kondensators angeschlossene Auslese- und Rücksetzschaltung vorgesehen.

Aufbau und Funktionsweise der erfindungsgemäßen Schaltungsanordnung werden nachfolgend anhand von Ausführungsbeispielen in Figuren näher erläutert. Es zeigen:

Figur 1    Schaltbild einer Ausführungsform der erfindungsgemäßen Schaltungsanordnung;

Figur 2    Kurve des elektrischen Feldes $E_i$ in dem ferroelektrischen Speicherdielektrikum in Abhängigkeit von dem an den Kondensator von außen angelegten elektrischen Feld $E_e$;

Figur 3    erfindungsgemäße Schaltungsanordnung mit externer Verschaltung bei Verwenden einer Anzahl Sensoren und Kondensatoren in einer matrixartigen Sensor und Speicheranordnung;

Figur 4    Querschnitt durch eine in einem Halbleiterkörper integrierte erfindungsgemäße Schaltungsanordnung.

In den Figuren bezeichnen, sofern nicht anders angegeben, gleiche Bezugszeichen gleiche Bauteile mit gleicher Bedeutung.

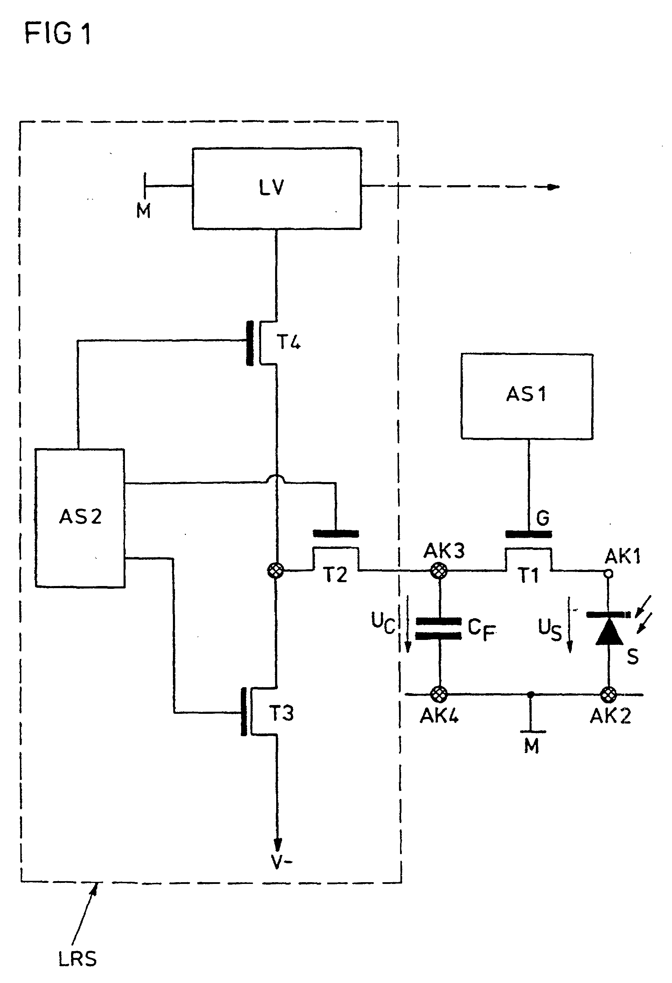

In Figur 1 ist ein Schaltbild der erfindungsgemäßen Schaltungsanordnung mit einem Sensor S und einem ein ferroelektrisches Speicherdielektrikum aufweisenden Kondensator $C_F$ dargestellt. Der Kondensator $C_F$ und der in dem dargestellten Beispiel als Fotodiode ausgebildete Sensor S sind mit einer Anschlußklemme AK2, AK4 jeweils an ein gemeinsames Bezugspotential M angeschlossen. Eine andere Anschlußklemme AK3 des Kondensators $C_F$ ist über die Laststrecke eines als Schalter wirkenden Feldeffekttransistors T1 mit einer anderen Anschlußklemme AK1 des Sensors S verbunden. Zur Ansteuerung des Transistors T1 ist eine erste Ansteuerschaltung AS1 vorgesehen, die an den Gate-Anschluß G des Transistors T1 angeschlossen ist und die durch Ansteuerung des Transistors T1 den Zeitpunkt und die Zeitdauer bestimmt, für die eine leitende Verbindung zwischen dem Kondensator $C_F$ und dem Sensor S besteht.

Die Funktionsweise der Schaltungsanordnung soll im nachfolgenden für die Verwendung einer Fotodiode als Sensor S beschrieben werden.

Bei Lichteinfall an der Fotodiode S fällt zwischen deren Anschlußklemme AK1, AK2 eine annähernd konstante Spannung an, wobei der von der Fotodioge S gelieferte Strom von der Intensität des einfallenden Lichts abhängig ist.

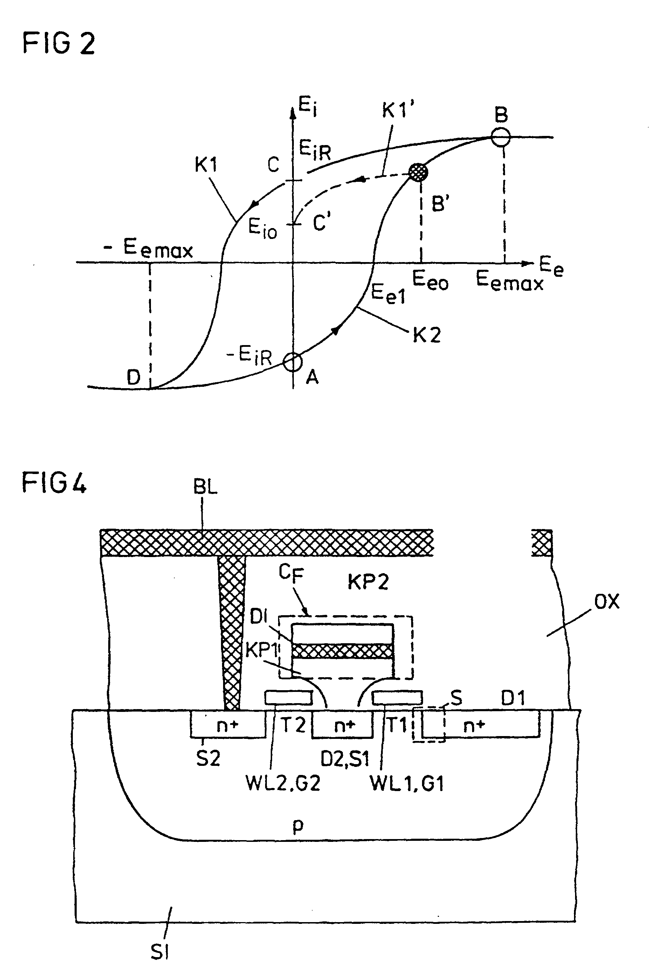

Die Verwendung eines ferroelektrischen Dielektrikums in dem Kondensator $C_F$ ermöglicht wenigstens einen Teil der von der Fotodiode S bei leitendem Transistor T1 auf den Kondensator $C_F$ fließenden Ladung dauerhaft zu speichern. Das Phänomen dieser dauerhaften Ladungsspeicherung wird anhand der in Figur 2 dargestellten Hysteresekurve deutlich, die den Verlauf eines sich im Inneren des ferroelektrischen Dielektrikums ausbildenden elektrischen Feldes $E_i$ in Abhängigkeit von einem an Kondensatorplatten - zwischen denen sich das Dielektrikum befindet - angelegten äußeren elektrischen Feldes $E_e$ dargestellt ist. Diese äußere elektrische Feld $E_e$ ist abhängig von der zwischen Anschlußklemmen des Kondensators $C_F$ anliegenden Spannung $U_c$.

Bei Anliegen eines äußeren elektrischen Feldes $E_e$ bildet sich in dem ferroelektrischen Dielektrikum ein inneres Feld $E_i$ aus, dessen Werte auf unterschiedlich verlaufenden Kurvenabschnitten K1, K2 liegen, je nach dem, ob das äußere elektrische Feld $E_e$ ausgehend von einem negativen Wert $-E_{emax}$ hin zu positiven Werten zunimmt oder ob das äußere elektrische Feld $E_e$ ausgehend von einem positiven Wert $E_{emax}$ hin zu negativen Werten abnimmt. Ab einem als unterem Sättigungspunkt D bezeichneten Punkt der Hysteresekurve verlaufen die Kurvenabschnitte K1 und K2 gemeinsam, wenn der Betrag des negativen äußeren elektrischen Feldes über den Wert $E_{emax}$ hinausgeht. Ebenso verlaufen die Kurvenabschnitte K1, K2 ab einem oberen Sättigungspunkt B gemeinsam, wenn der Betrag des positiven äußeren elektrischen Feldes $E_e$ den Wert $E_{emax}$ übersteigt.

Wird durch Anlegen eines negativen äußeren elektrischen Feldes $E_e$ die Hysteresekurve bis hin zu dem unteren Sättigungspunkt D durchlaufen und das äußere elektrische Feld $E_e$ bzw. eine an den Kondensatorklemmen AK3, AK4 anliegende Spannung abgeschaltet, wird in dem Speicherdielektrikum ein negatives inneres elektrisches Feld vom Wert $-E_{iR}$ aufrechterhalten, wie aus Fig. 2 bei Punkt A der Hysteresekurve deutlich wird. Bei Durchlaufen der Hysteresekurve bis hin zu dem oberen Sättigungspunkt B durch Anlegen eines positiven äußeren elektrischen Feldes verbleibt nach Abschalten des äußeren Feldes ein positives inneres elektrisches Feld vom Wert $E_{iR}$ in dem Speicherdielektrikum, wie bei Punkt C der Hysteresekurve deutlich wird.

Das nach Wegnehmen des äußeren elektrischen Feldes $E_e$ verbleibende innere elektrische Feld $E_i$ resultiert aus einer dauerhaften Polarisation des ferroelektrischen Dielektrikums, wobei das Ausmaß der Polarisation und damit die Stärke des inneren elektrischen Feldes von dem Wert des zuvor angelegten äußeren elektrischen Feldes $E_e$ abhängt. Wird die Hysteresekurve beispielsweise durch Anlegen eines kleineren positiven äußeren elektrischen Feldes $E_e$ lediglich bis hin zum Punkt B' durchlaufen, erfolgt eine weniger starke Polarisation des Dielektrikums, so daß nach Wegnahme des äußeren elektrischen Feldes $E_e$ ein geringeres inneres elektrisches Feld vom Wert $E_{i0}$ verbleibt. Eine betragsmäßige Vergrößerung des negativen oder positiven äußeren elektrischen Feldes $E_e$ über $E_{emax}$, bzw. über die Sättigungspunkte D und B, hinaus, bewirkt keine betragsmäßige Vergrößerung des nach Abschalten des äußeren elektrischen Feldes $E_e$ verbleibenden inneren elektrischen Feldes $E_i$.

Mit dem nach Wegnahme des äußeren elektrischen Feldes $E_e$ durch Polarisation des Dielektrikums verbleibenden inneren elektrischen Feldes $E_i$ ist eine dauerhafte Ladungsspeicherung auf den Kondensatorplatten des Kondensators $C_F$ verbunden, wobei der Wert der gespeicherten Ladung von dem Wert des inneren elektrischen Feldes und damit von dem zur Einspeicherung der Ladung angelegten äußeren elektrischen Feld $E_e$ bzw. von der zwischen den Kondensatorklemmen AK3, AK4 anliegenden Spannung $U_C$ abhängt.

Der Ablauf eines Speichervorganges soll im folgenden erläutert werden, wobei als Sensor S beispielhaft eine Fotodiode angenommen ist, die bei Lichteinfall eine annäherungswiese konstante positive Spannung zwischen ihren Anschlußklemmen AK1, AK2 erzeugt und damit bei Parallelschaltung zu dem Kondensator $C_F$ ein positives äußeres elektrisches Feld zwischen den Kondensatorplatten bewirkt. Die Fotodiode liefert einen Strom, der abhängig von der Beleuchtungsstärke ist, die Helligkeitsinformation ist damit auf den von dem Sensor gelieferten Strom abgebildet.

Vor Einspeichern einer von dem Sensor S gelieferten Ladung wird der Kondensator $C_F$ "zurückgesetzt". Dies erfolgt durch Anlegen einer negativen Spannung, durch welche die in Figur 2 dargestellte Hysteresekurve bis zum unteren Sättigungspunkt D durchlaufen wird. Das Anlegen der negativen Spannung kann, wie in Figur 1 dargestellt, durch Verbinden der Anschlußklemme AK3 des Kondensators $C_F$ mit einer Klemme für ein Potential V- erfolgen, welches gegenüber dem Bezugspotential M negativ ist. Wie oben erläutert, verbleibt nach Abschalten der negativen Spannung in dem Speicherdielektrikum ein negatives inneres elektrisches Feld vom Wert $-E_{iR}$.

Bei nachfolgendem Parallelschalten des Kondensators $C_F$ zu dem Sensor S durch Schließen des Transistors T1 fließt bei Lichteinfall an dem Sensor S eine von dem Sensor S generierte Ladung auf die Kondensatorplatten des Kondensators $C_F$. Diese Ladung bewirkt ein äußeres elektrisches Feld $E_e$, wodurch wiederum der Wert des inneren elektrischen Feldes $E_i$ von dem Wert $-E_{iR}$ im Punkt A der Hysteresekurve gemäß dem Kurvenverlauf des Kurvenabschnitts K2 in Richtung des oberen Sättigungspunktes B ansteigt. Nach Öffnen des Transistors T1 fließt keine weitere Ladung auf den Kondensator $C_F$. Die sich zwischen den Kondensatorklemmen durch den Ladungsfluß aufgebaute Spannung $U_c$ bzw. das äußere elektrische Feld $E_e$ bleibt nach Öffnen des Schalters T1 zunächst erhalten. Unvermeidliche Leckströme bewirken allerdings, daß ein Teil der auf den Kondensatorplatten gespeicherten Ladung abfließt, bis das äußere elektrische Feld $E_e$ zu Null wird. Auf den Kondensatorplatten bleibt der Teil der Ladung dauerhaft gespeichert, der aus dem nach Wegnahme des äußeren elektrischen Feldes $E_e$ verbleibenden inneren elektrischen Feld $E_i$ resultiert. Erfolgt kein Lichteinfall an der Fotodiode S und fließt somit keine Ladung auf den Kondensator $C_F$ verbleibt das innere elektrische Feld auf dem Wert $-E_{iR}$.

Der Kondensator ist sowohl als analoges als auch als digitales Speichermedium geeignet. Zur Verwendung als analoges Speichermedium ist sicherzustellen, daß das äußere elektrische Feld $E_e$ nach dem Zurücksetzen des Kondensators Werte zwischen 0 und kleiner $E_{emax}$ annimmt, das innere elektrische Feld $E_i$ nimmt dann nach Wegnahme des äußeren elektrischen Feldes Werte zwischen $-E_{iR}$ und $E_{iR}$ an. Die dauerhaft auf den Kondensatorplatten gespeicherte Ladung ist proportional zu dem verbleibenden inneren elektrischen Feld $E_i$ und damit abhängig von dem zum Speichern an dem Kondensator anliegenden äußeren elektrischen Feld $E_e$. Der Wert des äußeren elektrischen Feldes ist abhängig von der bei geschlossenem Transistor T1 auf die Kondensatorplatten fließenden Ladung, wobei zwischen dem äußeren elektrischen Feld $E_e$ und der auf die Kondensatorplatten fließenden Ladung Q folgende Beziehung besteht:

$$E_e = Q/(A \cdot \varepsilon),$$

wobei A die Kondensatorfläche and $\varepsilon$ die Dielektrizitätskonstante des Speicherdielektrikums bezeichnet.

Die auf die Kondensatorplatten fließende Ladung hängt zum anderen von der zwischen den Anschlußklemmen AK1, AK2 des Sensors S anfallenden Spannung und von der Zeitdauer ab, während der der geschlossene Transistor einen Ladungsfluß ermöglicht. Die Parameter Kondensatorfläche A, Spannungsabfall $U_S$ an dem Sensor und Schließdauer des Transistors T1, sind zur Speicherung analoger Werte so aufeinander abgestimmt, daß der Wert des positiven äußeren elektrischen Feldes stets Werte kleiner oder gleich $E_{emax}$ annimmt. So kann beispielsweise durch eine Vergrößerung der Kondensatorfläche der Anstieg des äußeren elektrischen Feldes $E_e$ bei gleichbleibendem Stromfluß verlangsamt und damit die Empfindlichkeit der Anordnung gesteigert werden. Die Kondensatorflächen sind ferner so groß zu wählen, daß der Kondensator $C_F$ nicht sofort in Sättigung geht, wenn bei geschlossenem Transistor T1 Ladung von dem Sensor S geliefert wird.

Der Sensor S und der Kondensator $C_F$ sind gemäß einer ersten Ausführungsform so aufeinander abgestimmt, daß die an dem Sensor $U_S$ anfallende Spannung ausreicht, den Kondensator bis zum oberen Sättigungspunkt zu bringen, der Sensor S also ein äußeres Feld $E_e$ bewirkt, dessen Wert größer oder gleich $E_{emax}$ ist, wenn der Transistor T1 ausreichend lange geschlossen ist. Die Helligkeitsinformation ist bei Verwendung einer Fotodiode auf den von der Fotodiode gelieferten Strom abgebildet. Da der Kondensator $C_F$ lediglich eine bestimmte Ladungsmenge aufnehmen kann, bevor er in Sättigung geht, ermöglicht der Transistor T1 lediglich einen Stromfluß für eine vorgegebene Zeitdauer, wodurch aus der in dem Kondensator $C_F$ gespeicherten Ladung auf den zur Speicherung fließenden Strom und damit auf die Helligkeitsformation an dem Sensor zurückgeschlossen werden kann. Die Zeitdauer während der der Transistor T1 geschlossen ist, entspricht der Blendendauer bei Fotoapparaten. So besteht auch bei der erfindungsgemäßen Erfindung die Möglichkeit, die Blendendauer bei großer Beleuchtungsstärke zu verringern, um eine Sättigung des Kondensators $C_F$ aufgrund des bei großer Helligkeit von dem Sensor S gelieferten großen Ladungsstromes zu verhindern.

Eine weitere Ausführungsform sieht vor, einen Sensor zu verwenden, der abhängig von der Helligkeit unterschiedlich Spannungswerte zwischen seinen Ausgangsklemmen AK1, AK2 liefert. Die Helligkeitswerte an dem Sensor werden damit auf unterschiedliche Spannungswerte an dem Sensor abgebildet. Diese unterschiedlichen Spannungswerte rufen unterschiedliche Werte des äußeren elektrischen Feldes $E_e$ an dem Kondensator $C_F$ hervor, wobei der Sensor so gewählt ist, daß die Spannungen zwischen seinen Anschlußklemmen, keine Werte des äußeren elektrischen Feldes größer als $E_{emax}$ bewirken, um analoge Werte zu speichern. Die Zeitdauer während der der Transistor geschlossen ist, kann bei dieser Ausführungsform sehr lange sein, bzw. es kann auf den Transistor T1 verzichtet werden.

Zur Verwendung des Kondensators als digitales Speichermedium sind der Sensor S und die Kondensatorfläche A des Kondensators $C_F$ so aufeinander abgestimmt, daß der Kondensator $C_F$ immer in Sättigung geht, wenn er parallel zu dem Sensor S angeschlossen ist und der Sensor aufgrund Belichtung einen Ladungsstrom liefert. Der Sensor S ist für diese Ausführungsform vorzugsweise als Fotodiode ausgebildet, wobei die bei Lichteinfall zwischen ihren Anschlußklemmen AK1, AK2 anfallende Spannung $U_S$ ausreicht, um den Kondensator in Sättigung zu bringen. Um stets eine Sättigung des Kondensators bei Fließen eines Ladungsstroms zu erreichen, werden beispielsweise eine sehr kleine Kondensatorfläche A bzw. lange Schließzeiten des Transistors T1 gewählt.

Zum Auslesen der über den Sensor S in den Kondensator $C_F$ gespeicherten Ladung ist eine Lese- und Rücksetzschaltung LRS vorgesehen. Die Lese- und Rucksetzschaltung LRS besitzt einen Leseverstärker LV, der über die Laststrecken dritter und vierter Transistoren T2, T4 an die erste Anschlußklemme AK3 des Kondensators $C_F$ angeschlossen ist. Die Ansteuerung der Transistoren T2, T4 erfolgt mittels einer zweiten Ansteuerschaltung AS2, die zum Auslesen der in den Kondensator $C_F$ gespeicherten Ladung die Transistoren T2, T4 leitend macht.

Nach Beendigung des Auslesevorganges wird der Kondensator $C_F$ zurückgesetzt, wobei die erste Anschlußklemme AK3 des Kondensators $C_F$ über die Laststrecke des Transistors T2 und die Laststrecke eines weiteren Transistors T3, der ebenfalls durch die zweite Ansteuerschaltung AS2 ansteuerbar ist, mit der Klemme für negatives Potential V- verbunden wird. Nach Abschluß des Lese- und Rücksetzvorganges sperrt der Transistor T2 angesteuert durch die Ansteuerschaltung AS2.

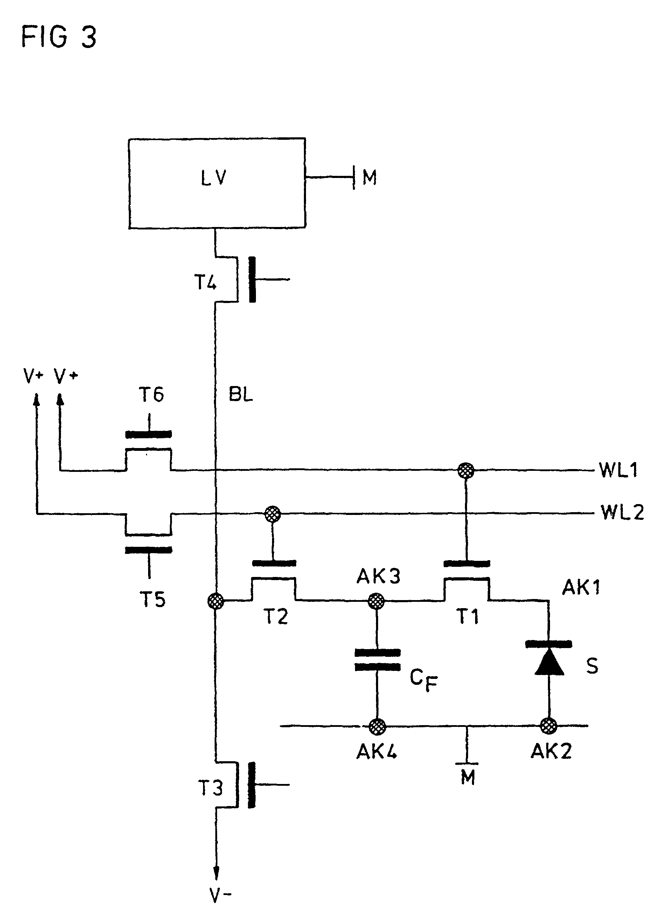

Figur 3 zeigt die erfindungsgemäße Schaltungsanordnung mit dem Sensor S, dem Kondensator $C_F$ und dem zwischen Anschlußklemmen AK1, AK3 des Sensors S und des Kondensators $C_F$ geschalteten Transistor T1 als Teil einer matrixartigen Anordnung einer derartigen Sensor- und Speicheranordnung, die jeweils einen Sensor S und einen Kondensator $C_F$ aufweisen. Jede Sensor- und Speichereinheit ist an eine Bitleitung BL und an jeweils zwei Wortleitungen WL1, WL2 angeschlossen, wobei jede Sensor- und Speichereinheit über die Bitleitungen BL und Wortleitungen WL1, WL2, an die sie angeschlossen ist, eindeutig identifizierbar ist. So sind keine zwei Sensor- und Speicheranordnungen an dieselben Bit- und Wortleitungen BL, WL1, WL2 angeschlossen. Eine erste Wortleitung WL1 dient zur Ansteuerung des zwischen dem Sensor S und dem Kondensator $C_F$ angeordneten Transistors T1, wobei die erste Wortleitung WL1 mittels eines Transistors T6 an ein Ansteuerpotential V+ anlegbar ist, welches ausreicht, die ersten Transistoren T1 leitend zu machen. Die Ansteuerung des Transistors T6 erfolgt mittels einer hier nicht näher dargestellten Ansteuerschaltung, wobei die Funktion dieser Ansteuerschaltung der in Figur 1 dargestellten ersten Ansteuerschaltung AS1 entspricht, da die ersten Transistoren so lange leiten, so lange der Transistor T6 leitet und die erste Wortleitung WL1 damit auf Ansteuerpotential V+ liegt. Bei Ansteuerung des Transistors T6 werden alle ersten Transistoren T1, die an die erste Wortleitung WL1 angeschlossen sind, leitend gemacht, um eine von den Sensoren S generierte Ladung auf den Kondensatoren $C_F$ zu speichern.

Des weiteren ist eine zweite Wortleitung WL2 vorgesehen, die an Steueranschlüsse der zweiten Transistoren T2 der Sensorund Speicheranordnungen angeschlossen ist. Die zweite Wortleitung WL2 ist über einen Transistor T5 an eine Klemme für Ansteuerpotential V+ anschließbar, wobei die zweiten Transistoren T2 leiten, wenn der Transistor T5 leitet und die Wortleitung WL2 auf Ansteuerpotential V+ liegt. Die Ansteuerung des Transistors T5 erfolgt mittels einer hier nicht näher dargestellten Ansteuerschaltung. Die Bitleitung BL weist einen dritten und vierten Transistor T3, T4 auf, deren Funktion der in Figur 1 dargestellten Transistoren T3, T4 entspricht. Die Ansteuerung dieser Transistoren T3, T4 erfolgt mittels einer hier nicht näher dargestellten Ansteuerschaltung, wobei der Transistor vierte T4 leitet, wenn auch der zweite Transistor T2 leitet und die in dem Kondensator $C_F$ gespeicherte Ladung über den Leseverstärker LV ausgelesen werden soll. Der dritte Transistor T3 leitet, wenn auch der zweite Transistor T2 leitet, um den Kondensator $C_F$ durch Anschluß an das negative Potential V- zurückzusetzen.

Der Leseverstärker LV dient in dem dargestellten Ausführungsbeispiel neben dem Auslesen der in den Kondensatoren $C_F$ gespeicherten Ladung zur Verstarkung und zur Weitergabe des ermittelten Wertes an weitere Verarbeitungseinheiten.

Figur 4 zeigt einen Querschnitt durch einen Halbleiterkörper, in dem eine Sensor- und Speicheranordnung mit einem Sensor S, einem ersten Transistor T1, einem Kondensator $C_F$ und einem zweiten Transistor T2 angeordnet ist. In ein Siliziumsubstrat S1 ist bei dieser Ausführungsform eine p-dotierte Wanne eindotiert. Die Transistoren T1, T2 sind als n-Kanal CMOS-Transistoren ausgebildet, wobei die Drain-Source-Gebiete der Transistoren T1, T2 als n+-dotierte Bereiche in der p-dotierten Wanne ausgebildet sind. Die Bezugszeichen G1, G2 bezeichnen in Figur 4 die Gate-Elektroden, die Bezugszeichen S1, S2 die Source-Bereiche und die Bezugszeichen D1, D2 die Drain-Bereiche der Transistoren T1, T2. Der erste und zweite Transistor T1, T2 besitzen ein gemeinsames Drain-Source-Gebiet D2,S1, welches oberhalb des Siliziumsubstrats S1 mit einer ersten Kondensatorplatte KP1 des Kondensators $C_F$ verbunden ist. Zwischen der ersten Kondensatorplatte KP1 und einer zweiten darüberliegenden Kondensatorplatte KP2 ist ein ferroelektrisches Dielektrikum D1 angeordnet. Das Source-Gebiet S2 des zweiten Transistors T2 ist über einen Kontakt K elektrisch leitend mit einer Bitleitung BL verbunden. Die Gate-Elektroden G1, G2 der ersten und zweiten Transistoren T1, T2 bilden gleichzeitig die ersten und zweiten Wortleitungen WL1, WL2, wobei die Bitleitung BL und die Wortleitungen WL1, WL2 bei der dargestellten Anordnung annäherungsweise senkrecht zueinander verlaufen.

Der in diesem Ausführungsbeispiel als lichtempfindliche Diode ausgebildete Sensor wird durch den pn-Übergang zwischen dem n+-dotierten Bereich D1, der gleichzeitig den Drain-Bereich D1 des ersten Transistors T1 darstellt, und der p-dotierten Wanne gebildet. Um einen Lichteinfall an dem n+-dotierten Bereich D1 zu ermöglichen, ist die Bitleitung BL an den Sensoren S vorbeigeführt und die über dem Siliziumsubstrat S1 aufgebrachte Isolationsschicht OX licht- bzw. strahlungsdurchlässig ausgebildet. Vorteilhafterweise ist die Isolationsschicht OX über dem n+-dotierten Bereich D1 gedünnt, um einen verbesserten Lichteinfall zun ermöglichen.

Die zweiten Kondensatorplatten KP2 aller Sensor- und Speicheranordnungen sind vorzugsweise als durchgehende Elektrodenplatte ausgeführt, die an ein Bezugspotential angeschlossen sind.

**Patentansprüche**

1. Schaltungsanordnung mit einem Sensor (S) und einem Speichermittel ($C_F$) zur nichtflüchtigen Speicherung einer von dem Sensor (S) gelieferten Ladung, wobei das Speichermittel ein Kondensator ($C_F$) mit einem ferroelektrischen Speicherdielektrikum ist, der wenigstens zeitweise mit dem Sensorelement (S) verbunden ist,
**dadurch gekennzeichnet,**

   - **dass** der Kondensator ($C_F$) parallel zu Anschlussklemmen des Sensorelements (S) angeschlossen ist und
   - **dass** eine Auslese- und Rücksetzungsschaltung (LRS) an Anschlussklemmen (AK3, AK4) des Kondensators ($C_F$) angeschlossen ist zum Auslesen der in dem Kondensator ($C_F$) gespeicherten Ladung.

2. Schaltungsanordnung nach Anspruch 1
**dadurch gekennzeichnet,**
**dass** das Sensorelement (S) eine Fotodiode oder ein Fototransistor ist.

3. Schaltungsanordnung nach Anspruch 1
**dadurch gekennzeichnet,**
**dass** das Sensorelement ein Hall-Sensor ist.

4. Schaltungsanordnung nach Anspruch 1
**dadurch gekennzeichnet,**
**dass** das Sensorelement ein Thermoelement ist.

5. Schaltungsanordnung nach einem der vorangehenden Ansprüche,

**dadurch gekennzeichnet,**
**dass** ein Schalter (T1) zwischen eine Klemme (AK3) des Kondensators ($C_F$) und eine Klemme (AK1) des Sensors (S) geschaltet ist.

6.  Schaltungsanordnung nach Anspruch 5,
    **dadurch gekennzeichnet,**
    **dass** der Schalter (T1) als Transistor ausgebildet ist, der mittels einer Ansteuerschaltung (AS1) ansteuerbar ist.

7.  Schaltungsanordnung nach einem der vorangehenden Ansprüche,
    **dadurch gekennzeichnet,**
    **dass** der Sensor (S) und der Kondensator ($C_F$) in einem Halbleiterkörper ausgebildet sind.

8.  Schaltungsanordnung nach einem der vorangehenden Ansprüche,
    **dadurch gekennzeichnet,**
    **dass** der Sensor (S), der Kondensator ($C_F$) und/oder Zeitdauern, während denen der Schalter (T1) geschlossen ist, so aufeinander abgestimmt sind, dass während eines Speichervorganges ein zwischen den Kondensatorklemmen (AK3, AK4) anliegendes elektrisches Feld unterhalb einem maximalen Wert ($E_{emax}$) bleibt, bei dem das ferroelektrische Dielektrikum in Sättigung geht.

9.  Schaltungsanordnung nach einem der Ansprüche 1 bis 7,
    **dadurch gekennzeichnet,**
    **dass** der Sensor (S), der Kondensator ($C_F$) und/oder Zeitdauern, während denen der Schalter (T1) geschlossen ist, so aufeinander abgestimmt sind, dass während eines Speichervorganges ein zwischen den Kondensatorklemmen (AK3, AK4) anliegendes elektrisches Feld stets einen maximalen Wert ($E_{emax}$) erreicht, bei dem das ferroelektrische Dielektrikum in Sättigung geht.

**Claims**

1.  Circuit arrangement having a sensor (S) and a storage means ($C_F$) for the nonvolatile storage of a charge delivered by the sensor (S), the storage means being a capacitor ($C_F$) having a ferroelectric storage dielectric which is at least intermittently connected to the sensor element (S),
    **characterized**

    -   **in that** the capacitor ($C_F$) is connected in parallel with connection terminals of the sensor element (S), and
    -   **in that** a read and reset circuit (LRS) is connected to connection terminals (AK3, AK4) of the capacitor ($C_F$) for the purpose of reading out the charge stored in the capacitor ($C_F$).

2.  Circuit arrangement according to Claim 1,
    **characterized**
    **in that** the sensor element (S) is a photodiode or a phototransistor.

3.  Circuit arrangement according to Claim 1,
    **characterized**
    **in that** the sensor element is a Hall sensor.

4.  Circuit arrangement according to Claim 1,
    **characterized**
    **in that** the sensor element is a thermoelement.

5.  Circuit arrangement according to one of the preceding claims,
    **characterized**
    **in that** a switch (T1) is connected between a terminal (AK3) of the capacitor ($C_F$) and a terminal (AK1) of the sensor (S).

6.  Circuit arrangement according to Claim 5,
    **characterized**
    **in that** the switch (T1) is in the form of a transistor which can be driven by means of a drive circuit (AS1).

7.  Circuit arrangement according to one of the preceding claims,
    **characterized**
    **in that** the sensor (S) and the capacitor ($C_F$) are formed in a semiconductor body.

8.  Circuit arrangement according to one of the preceding claims,
    **characterized**
    **in that** the sensor (S), the capacitor ($C_F$) and/or time periods during which the switch (T1) is on are coordinated with one another such that during a storage procedure an electrical field present between the capacitor terminals (AK3, AK4) remains below a maximum value ($E_{emax}$) at which the ferroelectric dielectric saturates.

9.  Circuit arrangement according to one of Claims 1 to 7,
    **characterized**
    **in that** the sensor (S), the capacitor ($C_F$) and/or time periods during which the switch (T1) is on are coordinated with one another such that during a storage procedure an electrical field present between the capacitor terminals (AK3, AK4) always reaches a maximum value ($E_{emax}$) at which the ferroelectric dielectric saturates.

**Revendications**

1. Circuit comportant un capteur (S) et une mémoire ($C_F$) pour la mémorisation non volatile d'une charge fournie par le capteur (S), la mémoire étant un condensateur ($C_F$) avec diélectrique de stockage ferroélectrique qui est relié au moins temporairement à l'élément capteur (S),

   **caractérisé par le fait que**

   - le condensateur ($C_F$) est branché en parallèle avec des bornes de connexion de l'élément capteur (S), et
   - un circuit de lecture et de remise à zéro (LRS) est raccordé à des bornes de connexion (AK3, AK4) du condensateur ($C_F$) pour lire la charge stockée dans le condensateur ($C_F$)

2. Circuit selon la revendication 1,
   **caractérisé par le fait que** l'élément capteur (S) est une photodiode ou un phototransistor.

3. Circuit selon la revendication 1,
   **caractérisé par le fait que** l'élément capteur est un capteur à effet Hall.

4. Circuit selon la revendication 1,
   **caractérisé par le fait que** l'élément capteur est un thermocouple.

5. Circuit selon l'une des revendications précédentes,
   **caractérisé par le fait qu'**un interrupteur (T1) est branché entre une borne (AK3) du condensateur ($C_F$) et une borne (AK1) du capteur (S).

6. Circuit selon la revendication 5,
   **caractérisé par le fait que** l'interrupteur (T1) est conçu comme un transistor qui peut être commandé au moyen d'un circuit de commande (AS1).

7. Circuit selon l'une des revendications précédentes,
   **caractérisé par le fait que** le capteur (S) et le condensateur ($C_F$) sont conçus dans un corps semiconducteur.

8. Circuit selon l'une des revendications précédentes,
   **caractérisé par le fait que** le capteur (S), le condensateur ($C_F$) et/ou la durée pendant laquelle l'interrupteur (T1) est fermé sont adaptés les uns aux autres de telle sorte que, pendant une opération de mémorisation, un champ électrique présent entre les bornes de condensateur (AK3, AK4) reste inférieur à une valeur maximale ($E_{emax}$) pour laquelle le diélectrique ferroélectrique arrive à saturation.

9. Circuit selon l'une des revendications 1 à 7,
   **caractérisé par le fait que** le capteur (S), le condensateur ($C_F$) et/ou la durée pendant laquelle l'interrupteur (T1) est fermé sont adaptés les uns aux autres de telle sorte que, pendant une opération de mémorisation, un champ électrique présent entre les bornes de condensateur (AK3, AK4) atteint toujours une valeur maximale ($E_{emax}$) pour laquelle le diélectrique ferroélectrique arrive à saturation.

# FIG 1

## FIG 2

## FIG 4

## FIG 3